# EUROPEAN PATENT APPLICATION

(11) **EP 4 622 412 A1**
(43) Date of publication of application: **24.09.2025**
(21) Application number: 24759042.5
(22) Date of filing: 04.02.2024
(51) Int. Cl.: H05K 7/20, G06F 1/20

(54) **IMMERSION LIQUID COOLING SYSTEM, CONTROL METHOD, AND CONTROL APPARATUS**

(71) Applicant: NEW H3C INFORMATION TECHNOLOGIES CO., LTD., Hangzhou, Zhejiang 310052 (CN)
(72) Inventor: XIN, Zhitao, Beijing 100102 (CN); WANG, Xinxin, Beijing 100102 (CN); FANG, Sen, Beijing 100102 (CN); CHEN, Libo, Beijing 100102 (CN)
(74) Representative: Zimmermann & Partner Patentanwälte mbB
(86) International application number: PCT/CN2024/075667
(87) International publication number: WO 2025/161001

(57) **Abstract**

Examples of the present disclosure provide an immersion liquid cooling system, a control method and a control apparatus, which relates to the technical field of liquid cooling and heat dissipation, the system comprises: a liquid cooling device, a first pump, a first condenser, a first solenoid valve, a second pump, a liquid storage device and a third solenoid valve; a gas area outlet of the liquid cooling device is connected to one end of the first pump, the other end of the first pump is connected to an inlet of the first condenser, and an outlet of the first condenser is connected to the first solenoid valve; the first solenoid valve is connected to an air discharge port; a liquid area inlet of the liquid cooling device is connected to one end of the second pump, and the other end of the second pump is connected to the liquid storage device; one end of the third solenoid valve is connected to the outlet of the first condenser, and the other end of the third solenoid valve is connected to a second inlet of the liquid storage device, the third solenoid valve is to control connection/disconnection of a pipeline between the first condenser and the second inlet of the liquid storage device. The waste of immersion liquid can be reduced.

## Description

### TECHNICAL FIELD

The present disclosure relates to the technical field of liquid cooling and heat dissipation, and in particular to an immersion liquid cooling system, a control method and a control apparatus.

### BACKGROUND

As the power consumption of the chip increases, the heat flow density of the chip becomes higher increasingly, and the heat dissipation of an electronic device where the chip is located becomes more and more difficult. The air-cooled heat dissipation method is no longer able to meet the heat dissipation needs of the electronic device. Therefore there is a new heat dissipation technology, a dual-phase immersion liquid cooling technology. The use of the dual-phase immersion liquid cooling technology can not only dissipate heat for the electronic device where high-power consumption chips are located, but also reduce the energy consumption of a data center where the electronic device is located, and achieving energy conservation and emission reduction, and so that the data center can meet the Power Usage Effectiveness (PUE) requirements.

The dual-phase immersion liquid cooling technology refers to immersing the electronic device in a liquid area of the liquid cooling device (TANK). The heat generated by the electronic device causes the immersed liquid to vaporize. Since the liquid vaporization process needs to absorb a large amount of heat, that is, the latent heat of vaporization, thereby cooling the electronic device. There is also a gas area in the liquid cooling device, and a condenser is provided in the gas area. After the vapor generated by the gasification of the liquid reaches the condenser, it will be cooled into liquid and fall back to the liquid area again.

However, the current air discharging process of the liquid cooling device requires opening a cover, which will cause a large amount of vapor generated by the vaporization of the immersion liquid to volatilize, resulting in the waste of immersion liquid.

### SUMMARY

The objective of examples of the present disclosure is to provide an immersion liquid cooling system, a control method and a control apparatus to reduce the waste of immersion liquid. The specific technical solutions are as follows:
In a first aspect, an example of the present disclosure provides an immersion liquid cooling system, which includes: a liquid cooling device, a first pump, a first condenser, a first solenoid valve, a second pump, a liquid storage device, and a third solenoid valve;
a gas area outlet of the liquid cooling device is connected to one end of the first pump, the other end of the first pump is connected to an inlet of the first condenser, and an outlet of the first condenser is connected to the first solenoid valve; the first solenoid valve is connected to an air discharge port for controlling an on/off state of the air discharge port;
a liquid area inlet of the liquid cooling device is connected to one end of the second pump, and the other end of the second pump is connected to the liquid storage device;
one end of the third solenoid valve is connected to the outlet of the first condenser, and the other end is connected to a second inlet of the liquid storage device, the third solenoid valve is to control connection/disconnection of a pipeline between the first condenser and the second inlet of the liquid storage device.

In a possible example, the system further includes a second solenoid valve;
a first inlet of the liquid storage device is connected to the second solenoid valve, and the second solenoid valve is connected to a liquid supplementing port for controlling an on/off state of the liquid supplementing port.

In a possible example, a second condenser is provided in a gas area of the liquid cooling device, the first condenser and the second condenser share a coolant outlet and a coolant inlet;
the coolant inlet is provided with an opening control valve, and a fourth solenoid valve is provided between the opening control valve and the first condenser, the fourth solenoid valve is to control connection/disconnection of a pipeline between the opening control valve and a condenser pipe inlet of the first condenser;
the opening control valve is further connected to a condenser pipe inlet of the second condenser.

In a possible example, the system further includes a first liquid discharge pipeline, a second liquid discharge pipeline, a first three-way valve and a second three-way valve;
the first three-way valve is located between the second pump and the liquid storage device, and the first three-way valve is connected to the first liquid discharge pipeline;
the second three-way valve is located between the liquid area inlet of the liquid cooling device and the second pump, and the second three-way valve is connected to the second liquid discharge pipeline.

In a possible example, the system further includes a third liquid discharge pipeline, a fourth liquid discharge pipeline, a first three-way valve, a second three-way valve and a fifth solenoid valve;
the first three-way valve is located between the second pump and the liquid storage device, and the second three-way valve is located between the liquid area inlet of the liquid cooling device and the second pump;
one end of the third liquid discharge pipeline is connected to an outlet of the second pump, and the other end is connected to a liquid discharge port, and the fifth solenoid valve is provided between the third liquid discharge pipeline and the second pump;
one end of the fourth liquid discharge pipeline is connected to the first three-way valve, and the other end of the fourth liquid discharge pipeline is connected to the second three-way valve.

In a possible example, a pressure gage is provided between the gas area outlet of the liquid cooling device and the first pump.

In a possible example, a liquid level sensor is provided in the liquid cooling device.

In a possible example, a liquid level sensor is provided in a liquid storage tank.

In a possible example, a control apparatus is provided in the liquid cooling device, and the control apparatus is to control the opening control valve, the first solenoid valve, and the second solenoid valve, the third solenoid valve, the fourth solenoid valve, the first pump, the second pump, the first three-way valve and the second three-way valve.

In a second aspect, an example of the present disclosure provides a control method for an immersion liquid cooling system, the immersion liquid cooling system is the system described in the first aspect, the method is applied to a control apparatus of a liquid cooling device, and the method includes:
when a device to be heat-dissipated in the liquid cooling device is started, turning on a first pump, a first solenoid valve, a third solenoid valve and a fourth solenoid valve, and turning off a second solenoid valve, so that the first pump extracts air and immersion liquid vapor from the liquid cooling device, allowing the air and immersion liquid vapor to enter a first condenser, immersion liquid condensed by the first condenser flows into a liquid storage device through the third solenoid valve with the air being discharged through the first solenoid valve and an air discharge port;
adjusting a first three-way valve to connect a second pump and the liquid storage device;
adjusting a second three-way valve to connect a liquid area inlet of the liquid cooling device and the second pump;
adjusting an opening degree of an opening control valve, to adjust pressure inside the liquid cooling device until the air discharging is completed.

In a possible example, adjusting the opening degree of the opening control valve, to adjust the pressure inside the liquid cooling device until the air discharging is completed, includes:
obtaining a pressure value collected by a pressure gage once every first preset time duration;
if pressure values collected after consecutive collections for a preset number of times show an increasing trend, reducing the opening degree of the opening control valve by a preset opening degree value;
after a second preset time duration, turning off the first pump, the first solenoid valve, the third solenoid valve and the fourth solenoid valve, and turning on the first pump, the first solenoid valve, the third solenoid valve and the fourth solenoid valve again;
returning to obtaining a pressure value collected by the pressure gage once every first preset time duration, until pressure values collected after consecutive collections for the preset number of times show a decreasing trend, determining that the air discharging is completed.

In a possible example, after determining that the air discharging is completed, the method further includes:
turning off the first pump, the first solenoid valve, the third solenoid valve and the fourth solenoid valve;
obtaining the pressure value collected by the pressure gage once every first preset time duration;
if the pressure value is greater than a first pressure threshold, then increasing the opening degree of the opening control valve by the preset opening degree value;
if the pressure value is less than a second pressure threshold, then reducing the opening degree of the opening control valve by the preset opening degree value.

In a possible example, the method further includes:
if the opening degree of the opening control valve reaches the maximum opening degree value, and if the pressure values collected after consecutive collections for the preset number of times show an increasing trend, turning on the third solenoid valve, the fourth solenoid valve, and the first pump;
if it is determined that a liquid level value recognized by a liquid level sensor in the liquid storage device is greater than or equal to a first preset height, turning on the second pump, and extracting immersion liquid in the liquid storage device through the second pump, so that the immersion liquid enters the liquid cooling device along a pipeline through the liquid area inlet of the liquid cooling device.

In a possible example, the method further includes:
increasing a power of the first pump by a preset power value if the pressure values collected after consecutive collections for the preset number of times show an increasing trend.

In a possible example, the method further includes:
if it is determined that a liquid level value recognized by the liquid level sensor of the liquid cooling device is less than a second preset height value, turning off the third solenoid valve and turning on the second solenoid valve, so that the immersion liquid entered from a liquid supplementing port flows into the liquid storage device;
using the second pump to extract the immersion liquid in the liquid storage device, so that the immersion liquid enters the liquid cooling device along the pipeline through the liquid area inlet of the liquid cooling device.

In a possible example, the method further includes:
during the process of supplementing liquid for the liquid cooling device, obtaining a pressure value collected by the pressure gage once every first preset time duration;
if the pressure values collected after consecutive collections for the preset number of times show an increasing trend, turning on the first pump, the first solenoid valve and the fourth solenoid valve;
if the change amplitude of the pressure values collected after consecutive collections for the preset number of times is less than a preset threshold, turning off the first pump, the first solenoid valve and the fourth solenoid valve.

In a possible example, when the immersion liquid cooling system includes a first liquid discharge pipeline and a second liquid discharge pipeline, the method further includes:
after the device to be heat-dissipated in the liquid cooling device is closed, adjusting the first three-way valve so that the first liquid discharge pipeline is connected to the second pump;
adjusting the second three-way valve so that the second pump is connected to the second liquid discharge pipeline;
opening a cover of the liquid cooling device, so that the immersion liquid in the liquid cooling device flows into the first liquid discharge pipeline, and turning on the second pump, using the second pump to extract the immersion liquid in the first liquid discharge pipeline, so that the immersion liquid flows out of a liquid discharge port through the second liquid discharge pipeline.

In a possible example, when the immersion liquid cooling system includes a third liquid discharge pipeline and a fourth liquid discharge pipeline, the method further includes:
after the device to be heat-dissipated in the liquid cooling device is closed, adjusting the second three-way valve so that the liquid cooling device is connected to the fourth liquid discharge pipeline;
adjusting the first three-way valve so that the fourth liquid discharge pipeline is connected to an inlet of the second pump;
turning on a fifth solenoid valve so that an outlet of the second pump is connected to the third liquid discharge pipeline;
opening a cover of the liquid cooling device so that the immersion liquid in the liquid cooling device flows into the fourth liquid discharge pipeline, and turning on the second pump, using the second pump to extract the immersion liquid in the fourth liquid discharge pipeline so that the immersion liquid flows out of a liquid discharge port through the third liquid discharge pipeline.

In a third aspect, an example of the present disclosure provide a control apparatus, which is located in a liquid cooling device of an immersion liquid cooling system described in the first aspect, and includes:
a switching module to turn on a first pump, a first solenoid valve, a third solenoid valve and a fourth solenoid valve when a device to be heat-dissipated in the liquid cooling device is started, and turn off a second solenoid valve so that the first pump extracts air and immersion liquid vapor from the liquid cooling device, and the air and immersion liquid vapor are allowed to enter a first condenser, immersion liquid condensed by the first condenser flows into a liquid storage device through the third solenoid valve, the air is discharged through the first solenoid valve and an air discharge port;
an adjustment module, to adjust a first three-way valve to connect a second pump and the liquid storage device; adjust a second three-way valve to connect a liquid area inlet of the liquid cooling device and the second pump; adjust an opening degree of an opening control valve, to adjust pressure inside the liquid cooling device until the air discharging is completed.

In a possible example, the adjustment module is specifically to:
obtain a pressure value collected by a pressure gage once every first preset time duration;
if pressure values collected after consecutive collections for a preset number of times show an increasing trend, reduce the opening degree of the opening control valve by a preset opening degree value;
after a second preset time duration, turn off the first pump, the first solenoid valve, the third solenoid valve and the fourth solenoid valve, and turn on the first pump, the first solenoid valve, the third solenoid valve and the fourth solenoid valve again;
return to the obtaining a pressure value collected by the pressure gage once every first preset time duration, until pressure values collected after consecutive collections for the preset number of times show a decreasing trend, then determine that the air discharging is completed.

In a possible example, the switching module is further to turn off the first pump, the first solenoid valve, the third solenoid valve and the fourth solenoid valve;
the adjustment module is further to obtain a pressure value collected by the pressure gage once every first preset time duration; if the pressure value is greater than a first pressure threshold, then increase the opening degree of the opening control valve by the preset opening degree value; if the pressure value is less than a second pressure threshold, then reduce the opening degree of the opening control valve by the preset opening degree value.

In a possible example, the switching module is further to:
if the opening degree of the opening control valve reaches a maximum opening degree value, and if the pressure values collected after consecutive collections for the preset number of times show an increasing trend, turn on the third solenoid valve, the fourth solenoid valve, and the first pump;
if it is determined that a liquid level value recognized by a liquid level sensor in the liquid storage device is greater than or equal to a first preset height, turn on the second pump, and extract immersion liquid in the liquid storage device through the second pump, so that the immersion liquid enters the liquid cooling device along a pipeline through the liquid area inlet of the liquid cooling device.

In a possible example, the adjustment module is further to increase the power of the first pump by a preset power value if the pressure values collected after consecutive collections for the preset number of times show an increasing trend.

In a possible example, the switching module is further to:
if it is determined that a liquid level value recognized by the liquid level sensor of the liquid cooling device is less than a second preset height value, turn off the third solenoid valve and turn on the second solenoid valve, so that the immersion liquid entered from a liquid supplementing port flows into the liquid storage device;
use the second pump to extract the immersion liquid in the liquid storage device, so that the immersion liquid enters the liquid cooling device along the pipeline through the liquid area inlet of the liquid cooling device.

In a possible example, the switching module is further to:
during the process of supplementing liquid for the liquid cooling device, obtain a pressure value collected by the pressure gage once every first preset time duration;
if pressure values collected after consecutive collections for the preset number of times show an increasing trend, turn on the first pump, the first solenoid valve and the fourth solenoid valve;
if a change amplitude of the pressure values collected after consecutive collections for the preset number of times is less than a preset threshold, turn off the first pump, the first solenoid valve and the fourth solenoid valve.

In a possible example, when the immersion liquid cooling system includes a first liquid discharge pipeline and a second liquid discharge pipeline, the adjustment module is further to, after the device to be heat-dissipated in the liquid cooling device is closed, adjust the first three-way valve so that the first liquid discharge pipeline is connected to the second pump; and adjust the second three-way valve so that the second pump is connected to the second liquid discharge pipeline;
the switching module is further to open a cover of the liquid cooling device, so that the immersion liquid in the liquid cooling device flows into the first liquid discharge pipeline, and turn on the second pump, use the second pump to extract the immersion liquid in the first liquid discharge pipeline, so that the immersion liquid flows out of a liquid discharge port through the second liquid discharge pipeline.

In a possible example, when the immersion liquid cooling system includes a third liquid discharge pipeline and a fourth liquid discharge pipeline, the adjustment module is further to, after the device to be heat-dissipated in the liquid cooling device is closed, adjust the second three-way valve so that the liquid cooling device is connected to the fourth liquid discharge pipeline; adjust the first three-way valve so that the fourth liquid discharge pipeline is connected to an inlet of the second pump;
the switching module is further to turn on a fifth solenoid valve so that an outlet of the second pump is connected to the third liquid discharge pipeline; open a cover of the liquid cooling device so that the immersion liquid in the liquid cooling device flows into the fourth liquid discharge pipeline, and turn on the second pump, and use the second pump to extract the immersion liquid in the fourth liquid discharge pipeline so that the immersion liquid flows out of a liquid discharge port through the third liquid discharge pipeline.

In a fourth aspect, an example of the present disclosure provides a control apparatus, which is located in a liquid cooling device of an immersion liquid cooling system described in the first aspect, and includes:
a processor;
a transceiver;
a machine-readable storage medium, having stored therein machine-executable instructions that can be executed by a processor, which cause the processor to:
   turn on a first pump, a first solenoid valve, a third solenoid valve and a fourth solenoid valve when a device to be heat-dissipated in the liquid cooling device is started, and turn off a second solenoid valve so that the first pump extracts air and immersion liquid vapor from the liquid cooling device, and the air and immersion liquid vapor are allowed to enter a first condenser, immersion liquid condensed by the first condenser flows into a liquid storage device through the third solenoid valve, the air is discharged through the first solenoid valve and an air discharge port;
   adjust a first three-way valve to connect a second pump and the liquid storage device;
   adjust a second three-way valve to connect a liquid area inlet of the liquid cooling device and the second pump;
   adjust an opening degree of an opening control valve, to adjust pressure inside the liquid cooling device until the air discharging is completed.

In a possible example, the machine-executable instructions further cause the processor to:
obtain a pressure value collected by a pressure gage once every first preset time duration;
if pressure values collected after consecutive collections for a preset number of times show an increasing trend, reduce the opening degree of the opening control valve by a preset opening degree value;
after a second preset time duration, turn off the first pump, the first solenoid valve, the third solenoid valve and the fourth solenoid valve, and turn on the first pump, the first solenoid valve, the third solenoid valve and the fourth solenoid valve again;
return to the obtaining a pressure value collected by the pressure gage once every first preset time duration, until pressure values collected after consecutive collections for the preset number of times show a decreasing trend, then determine that the air discharging is completed.

In a possible example, the machine-executable instructions further cause the processor to:
turn off the first pump, the first solenoid valve, the third solenoid valve and the fourth solenoid valve;
obtain a pressure value collected by the pressure gage once every first preset time duration;
if the pressure value is greater than a first pressure threshold, then increase the opening degree of the opening control valve by the preset opening degree value;
if the pressure value is less than a second pressure threshold, then reduce the opening of the opening control valve by the preset opening degree value.

In a possible example, the machine-executable instructions further cause the processor to:
if the opening degree of the opening control valve reaches a maximum opening degree value, and if the pressure values collected after consecutive collections for the preset number of times show an increasing trend, turn on the third solenoid valve, the fourth solenoid valve, and the first pump;
if it is determined that a liquid level value recognized by a liquid level sensor in the liquid storage device is greater than or equal to a first preset height, turn on the second pump, and extract the immersion liquid in the liquid storage device through the second pump, so that the immersion liquid enters the liquid cooling device along a pipeline through the liquid area inlet of the liquid cooling device.

In a possible example, the machine-executable instructions further cause the processor to:
increase a power of the first pump by a preset power value if the pressure values collected after consecutive collections for the preset number of times show an increasing trend.

In a possible example, the machine-executable instructions further cause the processor to:
if it is determined that a liquid level value recognized by the liquid level sensor of the liquid cooling device is less than a second preset height value, turn off the third solenoid valve and turn on the second solenoid valve, so that the immersion liquid entered from the liquid supplementing port flows into the liquid storage device;
use the second pump to extract the immersion liquid in the liquid storage device, so that the immersion liquid enters the liquid cooling device along the pipeline through the liquid area inlet of the liquid cooling device.

In a possible example, the machine-executable instructions further cause the processor to:
during the process of supplementing liquid for the liquid cooling device, obtain a pressure value collected by the pressure gage once every first preset time duration;
if pressure values collected after consecutive collections for the preset number of times show an increasing trend, turn on the first pump, the first solenoid valve and the fourth solenoid valve;
if a change amplitude of the pressure values collected after consecutive collections for the preset number of times is less than the preset threshold, turn off the first pump, the first solenoid valve and the fourth solenoid valve.

In a possible example, when the immersion liquid cooling system includes a first liquid discharge pipeline and a second liquid discharge pipeline, the machine-executable instructions further cause the processor to:
after the device to be heat-dissipated in the liquid cooling device is closed, adjust the first three-way valve so that the first liquid discharge pipeline is connected to the second pump;
adjust the second three-way valve so that the second pump is connected to the second liquid discharge pipeline;
open a cover of the liquid cooling device, so that the immersion liquid in the liquid cooling device flows into the first liquid discharge pipeline, and turn on the second pump, use the second pump to extract the immersion liquid in the first liquid discharge pipeline, so that the immersion liquid flows out of a liquid discharge port through the second liquid discharge pipeline.

In a possible example, when the immersion liquid cooling system includes a third liquid discharge pipeline and a fourth liquid discharge pipeline, the machine executable instructions further cause the processor to:
after the device to be heat-dissipated in the liquid cooling device is closed, adjust the second three-way valve so that the liquid cooling device is connected to the fourth liquid discharge pipeline;
adjust the first three-way valve so that the fourth liquid discharge pipeline is connected to an inlet of the second pump;
turn on a fifth solenoid valve so that an outlet of the second pump is connected to the third liquid discharge pipeline; open a cover of the liquid cooling device so that the immersion liquid in the liquid cooling device flows into the fourth liquid discharge pipeline;
turn on the second pump, use the second pump to extract the immersion liquid in the fourth liquid discharge pipeline so that the immersion liquid flows out of a liquid discharge port through the third liquid discharge pipeline.

In a fifth aspect, an example of the present disclosure provides a machine-readable storage medium, having stored therein machine-executable instructions that, when called and executed by a processor, cause the processor to: carry out the method according to the second aspect above.

In a sixth aspect, an example of the present disclosure further provides a computer program product, which causes a processor to: carry out the method according to the second aspect above.

In the immersion liquid cooling system, control method and control apparatus provided by the examples of the present disclosure, since the gas area outlet of the liquid cooling device is connected in series to the first pump, the first condenser, the first solenoid valve and the air discharge port, by controlling the first pump and the first solenoid valve, the air in the gas area of the liquid cooling device is allowed to be discharged from the air discharge port, thus there is no need to open the cover of the liquid cooling device during the air discharging process. In addition, the first condenser is also connected to the third solenoid valve, and the third solenoid valve is connected to the liquid storage device. Therefore, during the air discharging process, the immersion liquid cooled by the first condenser can enter the liquid storage device, and finally return to the liquid area of the liquid cooling device through the second pump. It can be seen that there is no need to open the cover during the air discharging process, which can reduce the escape loss of the immersion liquid.

### BRIEF DESCRIPTION OF THE DRAWINGS

The accompanying drawings described here are used to provide a further understanding of the present disclosure and constitute a part of the same. The illustrative examples of the present disclosure and their descriptions are used to explain the present disclosure and do not constitute an improper limitation of the present disclosure.
Figure 1 is a schematic structural diagram of an immersion liquid cooling system provided by an example of the present disclosure;
Figure 2 is a schematic structural diagram of another immersion liquid cooling system provided by an example of the present disclosure;
Figure 3 is a flow chart of a control method for an immersion liquid cooling system provided by an example of the present disclosure;
Figure 4 is a schematic diagram of an air discharging mode of an immersion liquid cooling system provided by an example of the present disclosure;
Figure 5 is a schematic diagram of an energy-saving mode of an immersion liquid cooling system provided by an example of the present disclosure;
Figure 6 is a schematic diagram of an enhanced heat dissipation mode of an immersion liquid cooling system provided by an example of the present disclosure;
Figure 7 is a schematic diagram of a liquid supplementing mode of an immersion liquid cooling system provided by an example of the present disclosure;
Figure 8 is a schematic diagram of a liquid discharge mode of an immersion liquid cooling system provided by an example of the present disclosure;
Figure 9 is a schematic structural diagram of a control apparatus provided by an example of the present disclosure;
Figure 10 is a schematic structural diagram of another control apparatus provided by an example of the present disclosure.

### DETAILED DESCRIPTION

In order to make the objective, technical solutions and advantages of the present disclosure clearer and more understandable, the present disclosure will be described in more detail below with reference to the accompanying drawings and examples. Obviously, the described examples are only some, and not all, of the examples of the present disclosure. All other examples obtained based on the examples of the present disclosure by those skilled in the art fall within the scope of protection of the present disclosure.

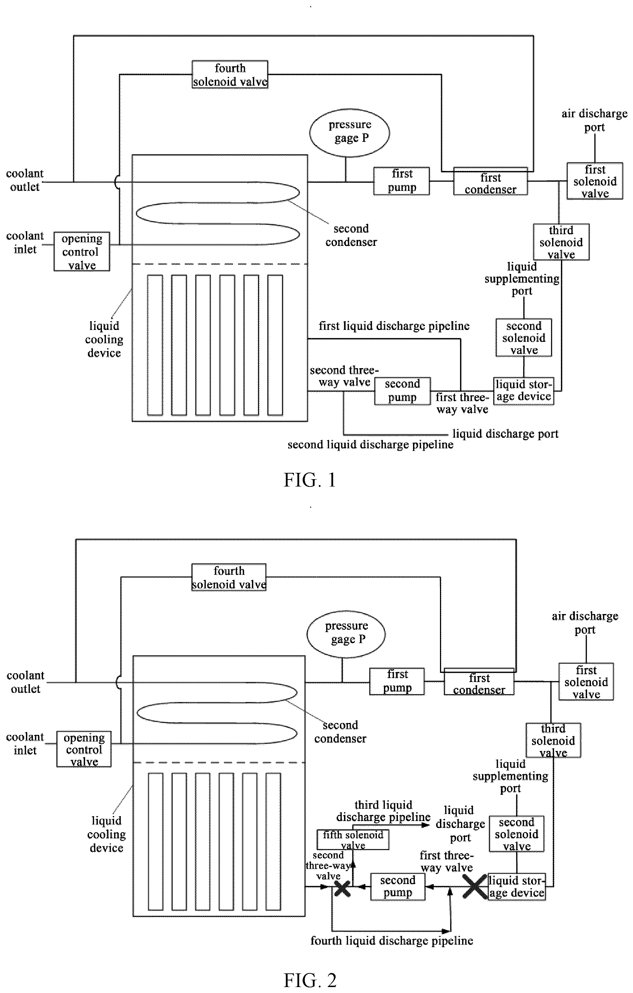

In order to avoid the waste of immersion liquid, an example of the present disclosure provides an immersion liquid cooling system, as shown in Figure 1, which includes a liquid cooling device, a first pump, a first condenser, a first solenoid valve, a second pump, a liquid storage device and a third solenoid valve; wherein, the first pump may be a vacuum pump or other pump capable of extracting gas, and the second pump may be a liquid pump.

A gas area outlet of the liquid cooling device is connected to one end of the first pump, the other end of the first pump is connected to an inlet of the first condenser, an outlet of the first condenser is connected to the first solenoid valve; the first solenoid valve is connected to an air discharge port, for controlling an on/off state of the air discharge port. Wherein, an upper portion of the liquid cooling device is a gas area, and a lower portion is a liquid area, with immersion liquid in the liquid area, and a device to be heat-dissipated is placed in the immersion liquid. A dotted line in Figure 1 represents a liquid level of the liquid cooling device, with the gas area being above the liquid level and the liquid area being below the liquid level. A rectangle in the liquid area represents the device to be heat-dissipated.

A liquid area inlet of the liquid cooling device is connected to one end of the second pump, and the other end of the second pump is connected to the liquid storage device. Wherein the liquid storage device is to accommodate immersion liquid condensed by the first condenser, and the liquid storage device may be a liquid storage tank or a liquid reservoir.

One end of the third solenoid valve is connected to the outlet of the first condenser, and the other end of the third solenoid valve is connected to a second inlet of the liquid storage device, the third solenoid valve is to control the connection/disconnection of a pipeline between the first condenser and the second inlet of the liquid storage device. Wherein, the liquid storage device also has a first inlet. In Figure 1, the first inlet of the liquid storage device is an inlet above the liquid storage device, and the second inlet is an inlet on the right side of the liquid storage device.

A passage between the gas area outlet of the liquid cooling device, the first pump, the first condenser and the first solenoid valve is a pipeline, when the first solenoid valve is turned on, the gas in the pipeline between the first condenser and the first solenoid valve can be discharged through the air discharge port.

Moreover, a passage between the first condenser, the third solenoid valve, the liquid storage device, the second pump and the liquid area inlet of the liquid cooling device is a pipeline. After passing through the first condenser, the immersion liquid vapor would be cooled into the immersion liquid, and then flow into the liquid storage device along this pipeline.

In the immersion liquid cooling system provided by the example of the present disclosure, since the gas area outlet of the liquid cooling device is connected in series with the first pump, the first condenser, the first solenoid valve and the air discharge port, the air in the gas area of the liquid cooling device is allowed to be discharged from the air discharge port by controlling the first pump and the first solenoid valve. Therefore there is no need to open a cover of the liquid cooling device during the air discharging process. In addition, the first condenser is further connected to the third solenoid valve, and the third solenoid valve is connected to the liquid storage device. Therefore, during the air discharging process, the immersion liquid cooled by the first condenser can enter the liquid storage device, and finally return to the liquid area of the liquid cooling device via the second pump. It can be seen that there is no need to open the cover during the air discharging process, which can reduce the escape loss of the immersion liquid.

In some examples of the present disclosure, as shown in Figure 1, the system further includes a second solenoid valve. The first inlet of the liquid storage device is connected to the second solenoid valve; the second solenoid valve is connected to a liquid supplementing port for controlling an on/off state of the liquid supplementing port. The liquid storage device is to accommodate immersion liquid injected from the liquid supplementing port.

In this way, the on/off state of the liquid supplementing port can be controlled by the second solenoid valve. When the second solenoid valve is turned on, the immersion liquid injected from the liquid supplementing port enters the liquid storage device, and the immersion liquid in the liquid storage device can enter the liquid cooling device under the action of the second pump, thereby achieving liquid supplementing. There is no need to open the cover during this process, which can reduce the escape loss of immersion liquid.

In some examples of the present disclosure, as shown in Figure 1, the gas area of the liquid cooling device is provided with a second condenser, and the first and second condensers share the coolant outlet and the coolant inlet; wherein, the second condenser can be in the form of a coil, the first condenser can be specifically a heat exchanger, with a coil provided inside the first condenser. When there is coolant in the coil, the immersion liquid vapor is condensed into the immersion liquid via the coil and would drip into a cavity of the first condenser, and then flow into the liquid storage device along the pipeline.

An opening control valve is provided at the coolant inlet, and a fourth solenoid valve is provided between the opening control valve and the first condenser, the fourth solenoid valve is to control the connection/disconnection of the pipeline between the opening control valve and a condensation pipe inlet of the first condenser.
the opening control valve is further connected to the condenser pipe inlet of the second condenser.

Wherein, the opening control valve is a valve which can adjust the opening degree, by adjusting the opening degree of the opening control valve, the flow rate of the coolant can be controlled. When the fourth solenoid valve is turned on, the coolant flowing through the coolant inlet enters the first condenser and the second condenser respectively, and the coolant both in the first condenser and the second condenser is discharged through the coolant outlet; when the fourth solenoid valve is turned off, the coolant flowing through the coolant inlet only flows into the second condenser.

In the example of the present disclosure, it can be flexibly adjusted whether there is coolant flowing into the inlet of the first condenser through the fourth solenoid valve. When air discharging is required, the fourth solenoid valve is turned on as needed, so that the first condenser condenses the immersion liquid vapor, thereby avoiding the waste of immersion liquid, and when the first condenser is not needed, the fourth solenoid valve can be flexibly turned off, thereby preventing the coolant from flowing into the first condenser. Moreover, the example of the present disclosure can adjust the pressure of the liquid cooling device through the opening degree of the opening control valve, which solves the problem in the prior art that internal pressure of the liquid cooling device cannot be adjusted.

In some examples of the present disclosure, the immersion liquid cooling system further includes a liquid discharge pipeline, and the examples of the present disclosure provide two ways of setting the liquid discharge pipeline.

Method 1. As shown in Figure 1, the immersion liquid cooling system further includes a first liquid discharge pipeline, a second liquid discharge pipeline, a first three-way valve and a second three-way valve;
the first three-way valve is located between the second pump and the liquid storage device, and the first three-way valve is connected to the first liquid discharge pipeline;
the second three-way valve is located between the liquid area inlet of the liquid cooling device and the second pump, and the second three-way valve is connected to the second liquid discharge pipeline.

Wherein, when the first three-way valve and the second three-way valve are turned on according to the main circuit, the first three-way valve is connected to the second pump and the liquid storage device, and the second three-way valve is connected to the liquid area inlet of the liquid cooling device and the second pump, at this time, the first liquid discharge pipeline is in a disconnected state, and the second liquid discharge pipeline is in a disconnected state.

Method 2. As shown in Figure 2, the immersion liquid cooling system further includes a third liquid discharge pipeline, a fourth liquid discharge pipeline, the first three-way valve, the second three-way valve and a fifth solenoid valve;
the first three-way valve is located between the second pump and the liquid storage device, and the second three-way valve is located between the liquid area inlet of the liquid cooling device and the second pump;
one end of the third liquid discharge pipeline is connected to the outlet of the second pump, the other end of the third liquid discharge pipeline is connected to a liquid discharge port, and the fifth solenoid valve is provided between the third liquid discharge pipeline and the second pump;
one end of the fourth liquid discharge pipeline is connected to the first three-way valve, and the other end of the fourth liquid discharge pipeline is connected to the second three-way valve.

Wherein, when the first three-way valve and the second three-way valve are turned on according to the main circuit, the first three-way valve is connected to the second pump and the liquid storage device, and the second three-way valve is connected to the liquid area inlet of the liquid cooling device and the second pump, at this time, the third liquid discharge pipeline is in a disconnected state, and the fourth liquid discharge pipeline is in a disconnected state.

It should be noted that the arrangement of the liquid discharge pipeline in Figure 2 is different from that in Figure 1, and Figure 2 further includes the fifth solenoid valve, and other components and connection relationships are the same as that in Figure 1.

In some examples of the present disclosure, as shown in Figures 1 and 2, a pressure gage is provided between the gas area outlet of the liquid cooling device and the first pump, and the pressure collected by the pressure gage represents the pressure inside of the liquid cooling device.

In an example, a liquid level sensor is provided in the liquid cooling device, and a liquid level sensor is provided in the liquid storage tank. The immersion liquid in the above examples may be fluorinated solution.

In the example of the present disclosure, a control apparatus is provided in the liquid cooling device, and the control apparatus is to control the opening control valve, the first solenoid valve, the second solenoid valve, the third solenoid valve, the fourth solenoid valve, the first pump, the second pump, the first three-way valve and the second three-way valve. It can be understood that the control apparatus is electrically connected to the opening control valve, the first solenoid valve, the second solenoid valve, the third solenoid valve, the fourth solenoid valve, the first pump, the second pump, the first three-way valve and the second three-way valve.

In an example, the control apparatus is electrically connected to the pressure gage, the liquid level sensor in the liquid cooling device, and the liquid level sensor in the liquid storage tank, and the control apparatus can obtain the pressure collected by the pressure gage and the liquid level value detected by the liquid level sensor.

Moreover, the control apparatus can be connected to a display screen, which can be located on the outer surface of the liquid cooling device, or can be an independent device, which is not limited in the examples of the present disclosure. The current working mode of the immersion liquid cooling system can be displayed on the display screen, and a user can adjust the current working mode of the immersion liquid cooling system through the display screen. In this way, the control apparatus can automatically control the immersion liquid cooling system, or control the immersion liquid cooling system according to the user's instructions, making it more flexible and intelligent.

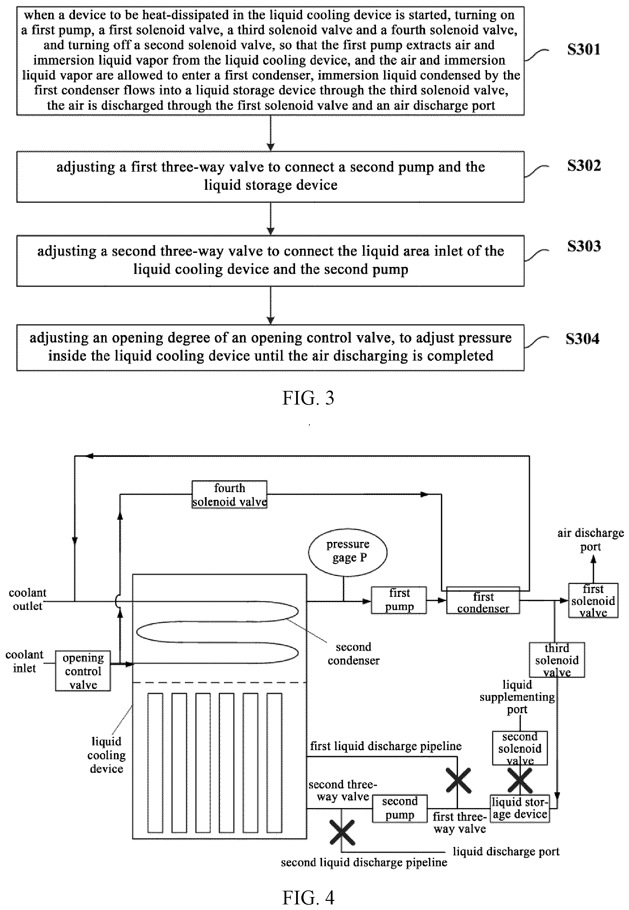

On the basis of the above examples, an example of the present disclosure provides a control method for an immersion liquid cooling system, the immersion liquid cooling system is the immersion liquid cooling system introduced in the above examples, the method is executed by the above control apparatus, as shown in Figure 3, the method includes:
S301. When a device to be heat-dissipated in the liquid cooling device is started, turning on a first pump, a first solenoid valve, a third solenoid valve and a fourth solenoid valve, and turning off a second solenoid valve, so that the first pump extracts air and immersion liquid vapor from the liquid cooling device, allowing the air and immersion liquid vapor to enter a first condenser, the immersion liquid condensed by the first condenser flows into a liquid storage device through the third solenoid valve with air being discharged through the first solenoid valve and an air discharge port.

Wherein, the device to be heat-dissipated in the liquid cooling device is an electronic device in the Internet Technology (IT) system of a data center, the electronic device can be a server, a router, a switch and other device that needs to be cooled.

When the IT system is just started, there is a large amount of air in the liquid cooling device, which will affect the condensation effect of a second condenser in the liquid cooling device, and will cause excessive pressure in the liquid cooling device, thereby affecting the boiling point of the immersion liquid. Therefore, when the IT device is just started, the immersion liquid cooling system needs to be adjusted to an air discharging mode to discharge the air in the liquid cooling device.

The air discharging mode of the immersion liquid cooling system is shown in Figure 4, the arrows in Figure 4 indicate flow directions in the pipeline, and the crossed position indicates that the pipeline is disconnected.

After the control apparatus turns on the first pump, the first solenoid valve, the third solenoid valve and the fourth solenoid valve, since the fourth solenoid valve is in the on-state, the pipeline between a coolant inlet and a condenser pipe inlet of the first condenser is connected, the coolant continuously entering from the coolant inlet can enter the condensation pipes of the first condenser and the second condenser respectively, and then be discharged from a coolant outlet after passing through the condensation pipes of the first condenser and the second condenser.

Moreover, the first pump is in an on-state and can extract air and immersion liquid vapor of a gas area of the liquid cooling device. The extracted immersion liquid vapor and air enter the first condenser along the pipeline. After the immersion liquid vapor contacts the condenser tube inside the first condenser, it undergoes a phase change into liquid, which is the immersion liquid. Then, since the first solenoid valve is in the on-state, the air passing through the first condenser can be discharged from the air discharge port. Moreover, the third solenoid valve is in an on-state, so the immersion liquid flowing out from the first condenser can flow into the liquid storage device along the pipeline.

S302. Adjusting a first three-way valve to connect a second pump and the liquid storage device.

S303. Adjusting a second three-way valve to connect a liquid area inlet of the liquid cooling device and the second pump.

It can be understood that the first three-way valve and the second three-way valve are both turned on according to the main path, and each of the drainage pipelines is in a disconnected state.

S304. Adjusting an opening degree of an opening control valve, to adjust pressure inside the liquid cooling device until the air discharging is completed.

Wherein, the opening degree of the opening control valve is negatively related to the pressure inside the liquid cooling device. After increasing the opening degree of the opening control valve, the flow rate of the coolant in the second condenser will increase, resulting in a faster condensation speed of the immersion liquid vapor, reducing the amount of immersion liquid vapor and lowering the pressure.

Using this method, since there is a large amount of air inside the liquid cooling device when the device to be heat-dissipated is just started, thus the first pump, the first solenoid valve, the third solenoid valve and the fourth solenoid valve are turned on, and the second solenoid valve is turned off. In this way, the first pump can extract the air and immersion liquid vapor in the liquid cooling device, so that the air can be discharged from the air discharge port after passing through the first condenser and the first solenoid valve. There is no need to open the cover of the liquid cooling device during the air discharging process, and avoiding the escape loss of immersion liquid vapor. And after the immersion liquid vapor is cooled into the immersion liquid through the second condenser, it can flow into the liquid storage device along the third solenoid valve. Since the first three-way valve and the second three-way valve allow the liquid storage device, the second pump and the liquid area inlet of the liquid cooling device to be connected, the immersion liquid stored in the liquid storage device can eventually return to the liquid cooling device, avoiding the waste of immersion liquid. During the air discharging process, by adjusting the opening control valve to control the pressure inside the liquid cooling device, the pressure inside the liquid cooling device can be kept stable, avoiding the deformation in the liquid cooling device due to too high or too low pressure, and ensuring that the air discharging is completed with no waste of immersion liquid.

In some examples of the present disclosure, the above-mentioned S304, adjusting the opening degree of the opening control valve to adjust the pressure inside the liquid cooling device until the air discharging is completed, can be implemented specifically as:
Block 1. Obtaining a pressure value collected by a pressure gage once every first preset time duration.

Wherein the control apparatus is electrically connected to the pressure gage and can obtain the latest pressure value collected by the pressure gage. The first preset duration may be set based on experience, for example, the first preset duration may be 3 seconds.

Block 2. If pressure values collected for a consecutive preset number of times show an increasing trend, reducing the opening degree of the opening control valve by a preset opening degree value.

Wherein the preset number of times can be set based on experience, for example, the preset number of times is 3. The preset opening degree value is the step size for each adjustment of the opening control valve, which can be preset based on experience.

Block 3. After a second preset time duration, turning off the first pump, the first solenoid valve, the third solenoid valve and the fourth solenoid valve, and turning on the first pump, the first solenoid valve, the third solenoid valve and the fourth solenoid valve again.

Wherein, the second preset time duration can be set based on experience. After the second preset time duration, that is, it is determined that one air discharging is completed, and then the first pump, the first solenoid valve, the third solenoid valve and the fourth solenoid valve are turned off and turned on again, to continue a second air discharging.

Block 4. Returning to block 1, until pressure values collected after consecutive collections for the preset number of times show a decreasing trend, then it is determined that the air discharging is completed.

After returning to block 1, the next air discharging process is initiated, with the same method used for each air discharging, until the pressure values collected after consecutive collections for the preset number of times show a decreasing trend, it is determined that the air discharging is completed.

Through experiments, it has been found that the pressure values can show a decreasing trend through three air discharging processes. Therefore, as another example, the number of air discharging can also be set to 3 times in advance, that is, after completing three times of air discharging, it is determined that the air discharging is completed.

In the example of the present disclosure, during the air discharging process, the opening control valve is adjusted according to the pressure of the liquid cooling device, thereby adjusting the pressure inside the liquid cooling device, ensuring that the air discharging is completed without causing deformation in the liquid cooling device.

In some examples of the present disclosure, after air discharging is completed, the liquid cooling system can enter an operation mode. The examples of the present disclosure provide two operation modes, an operation mode 1 is an energy-saving mode, and an operating mode 2 is an enhanced heat dissipation mode.

After the air discharging is completed, the control apparatus adjusts the liquid cooling system to the energy-saving mode by default, that is, after determining that the air discharging is completed, the method further includes: turning off the first pump, the first solenoid valve, the third solenoid valve and the fourth solenoid valve; obtaining a pressure value collected by the pressure gage once every first preset time duration; if the pressure value is greater than a first pressure threshold, then increasing the opening degree of the opening control valve by the preset opening degree value; if the pressure value is less than a second pressure threshold, then reducing the opening degree of the opening control valve by the preset opening degree value. Wherein, the first pressure threshold and the second pressure threshold are both preset based on experience, and the first pressure threshold is greater than the second pressure threshold.

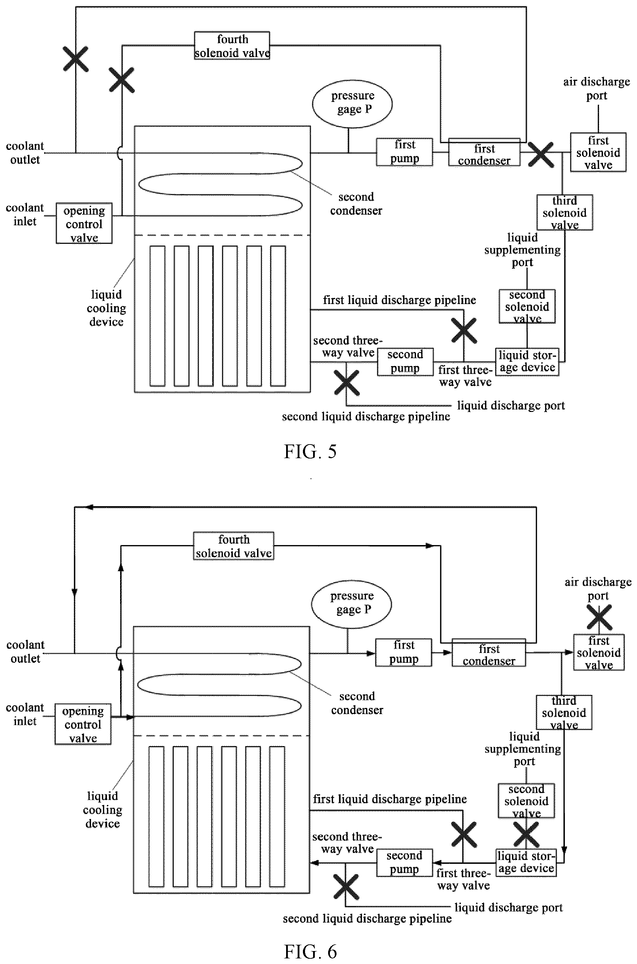

The energy-saving mode of the immersion liquid cooling system is shown in Figure 5. The first three-way valve and the second three-way valve are still opened according to the main circuit, only the opening control valve is used, and each of the solenoid valves, the second pump and the first pump are kept in off-states.

In the energy-saving mode, the air discharging operation is temporarily not performed. By adjusting the opening degree of the opening control valve to control the flow rate of coolant entering the second condenser, thereby adjusting the pressure inside the liquid cooling device, avoiding the deformation in the liquid cooling device due to too high or too low pressure and saving energy consumption.

When the immersion liquid cooling system is running in the energy-saving mode, if the pressure value continues to be greater than the first pressure threshold, the control apparatus will continue to increase the opening degree of the opening control valve. After the opening control valve is adjusted to a maximum opening degree, if the pressure value continues to increase, the control apparatus can adjust the operation mode of the immersion liquid cooling system to the enhanced heat dissipation mode. Based on this, the method further includes: if the opening degree of the opening control valve reaches the maximum opening value, and if the pressure values collected after consecutive collections for the preset number of times show an increasing trend, turning on the third solenoid valve, the fourth solenoid valve, and the first pump;
if it is determined that a liquid level value recognized by a liquid level sensor in the liquid storage device is greater than or equal to a first preset height, turning on the second pump, and extracting immersion liquid in the liquid storage device through the second pump, so that the immersion liquid enters the liquid cooling device along a pipeline through the liquid area inlet of the liquid cooling device.

Wherein the preset number of times is a preset experience value, as an example, the preset number of times can be 3. The first preset height is also a preset experience value, and the value is related to the height inside the liquid storage device, for example, the first preset height can be half of the height inside the liquid storage device.

The enhanced heat dissipation mode of the immersion liquid cooling system is shown in Figure 6, the opening control valve is at its maximum opening degree and the fourth solenoid valve is turned on, the coolant entering from the coolant inlet enters condenser pipes of the first condenser and the second condenser respectively, and flows out from the condenser pipe and is discharged through the coolant outlet.

And the first solenoid valve and the second solenoid valve are in off-states, the first pump and the third solenoid valve are in the on-states, and the first three-way valve and the second three-way valve are both turned on according to the main circuit. The immersion liquid vapor in the liquid cooling device can be extracted through the first pump. After the immersion liquid vapor is condensed in the first condenser, it is converted into immersion liquid, and then flows into the liquid storage device along the third solenoid valve.

When the liquid level value in the liquid storage device reaches the first preset height, the immersion liquid in the liquid storage device is allowed to flow into the liquid area of the liquid cooling device under the action of the second pump, thus achieving a closed-loop circulation of the immersion liquid in the immersion liquid cooling system, and reducing the escape waste of immersion liquid.

In the enhanced heat dissipation mode, the control apparatus can adjust the pressure in the liquid cooling device by adjusting the power of the first pump, thereby affecting the boiling point of the immersion liquid in the liquid cooling device. If the pressure values collected after consecutive collections for the preset number of times show an increasing trend, the power of the first pump can be increased by the preset power value, which reduces the pressure in the liquid cooling device, thereby lowering the boiling point of the immersion liquid, and making it easier for the immersion liquid to phase change into immersion liquid vapor, which can enhance the heat dissipation effect.

The control apparatus can determine whether the heat dissipation effect needs to be enhanced based on the pressure value in the liquid cooling device, for example, if the pressure values obtained within the consecutive preset number of times continue to increase, the power of the first pump can be increased by the preset power value.

Using this method, the operation mode of the immersion liquid cooling system can be automatically switched, and pressure control can be realized based on the pressure value inside the liquid cooling device, which is more intelligent and improves the heat dissipation effect on the basis of energy saving.

It should be noted that during the operation of the immersion liquid cooling system, the user can adjust the operation mode of the immersion liquid cooling system as needed through the display screen. After the control apparatus recognizes the user's adjustment operation, it can switch to the operation mode selected by the user according to the user's needs.

In some examples of the present disclosure, when it is determined that the liquid cooling device needs to be supplemented, the control apparatus may also start a liquid supplementing mode. That is, the method further includes: if it is determined that the liquid level value recognized by the liquid level sensor of the liquid cooling device is less than the second preset height value, turning off the third solenoid valve and turning on the second solenoid valve, so that the immersion liquid entering from the liquid supplementing port flows into the liquid storage device; using the second pump to extract the immersion liquid in the liquid storage device, so that the immersion liquid enters the liquid cooling device along the pipeline through the liquid area inlet of the liquid cooling device.

In an example, during the liquid supplementing process, the pressure value within the liquid cooling device will change, so the control apparatus also needs to control the pressure within the liquid cooling device based on the change in pressure value. That is, during the liquid supplementing process of supplementing liquid cooling device, a pressure value collected by the pressure gage is obtained once every first preset time duration;
if the pressure values collected after consecutive collections for the preset number of times show an increasing trend, turning on the first pump, the first solenoid valve and the fourth solenoid valve;
if a change amplitude of the pressure values collected after consecutive collections for the preset number of times is less than the preset threshold, turning off the first pump, the first solenoid valve and the fourth solenoid valve.

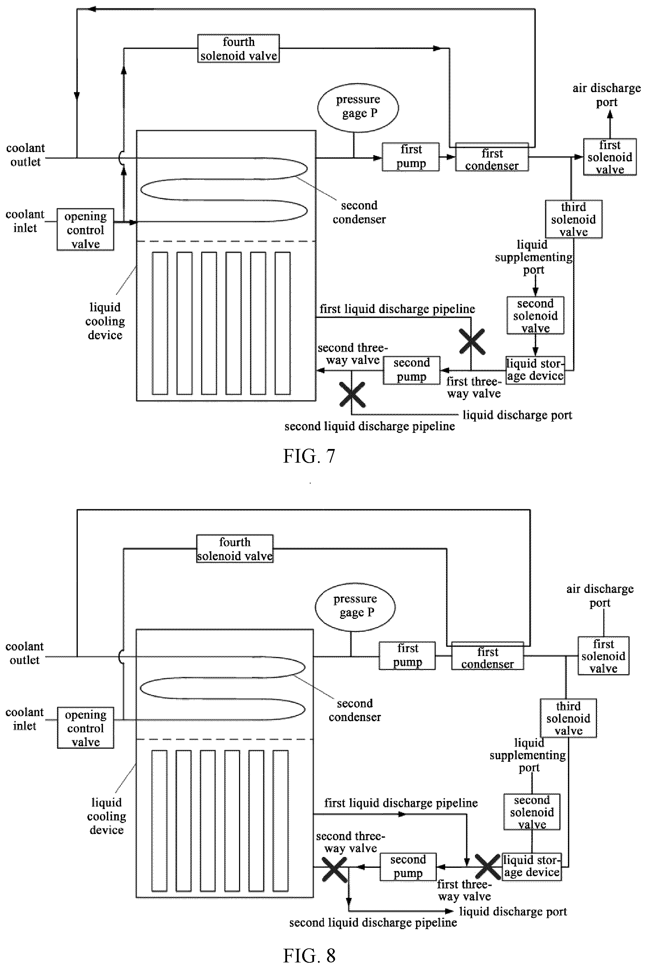

The liquid supplementing mode of the immersion liquid cooling system is shown in Figure 7. In the liquid supplementing mode, the third solenoid valve is in a normally off-state. When starting to drain liquid, the first pump, the first solenoid valve and the fourth solenoid valve are in off-states, and the second solenoid valve and the second pump are in on-states, the first three-way valve and the second three-way valve are turned on according to the main circuit.

The supplemented immersion liquid flows through the second solenoid valve through the liquid supplementing port, and then flows into the liquid storage device, then under the action of the second pump, the immersion liquid flowing into the liquid storage device is allowed to flow into the liquid area inlet of the liquid cooling device, thereby realizing liquid supplementing. During the liquid supplementing process, there is no need to open the cover of the liquid cooling device, and coolant continues to flow into the second condenser, that is, the second condenser is still in working condition, which does not affect the heat dissipation work.

It can be understood that as the immersion liquid flows into the liquid cooling device, the pressure value inside the liquid cooling device will increase. Therefore, the electronic device is still monitoring the pressure value inside the liquid cooling device. If the pressure values collected after consecutive collections for the preset number of times show an increasing trend, the first pump, the first solenoid valve and the fourth solenoid valve can be turned on, so that the air and immersion liquid vapor in the liquid cooling device enter the first condenser, and finally the air is discharged through the air discharge port, the immersion liquid condensed by the first condenser enters the liquid storage device. As the gas in the liquid cooling device is discharged, the pressure will also decrease.

If the change amplitude of the pressure values collected after consecutive collections for the preset number of times is less than the preset threshold, it means that the pressure in the liquid cooling device is relatively stable, and there is no need to perform an air discharging operation, that is, the first pump, the first solenoid valve and the fourth solenoid valve are kept in the off-states.

It should be noted that in Figure 7, the first pump, the first solenoid valve and the fourth solenoid valve are in on-states as an example.

In an example, during the liquid supplementing process, the pressure value in the liquid cooling device can also be adjusted by adjusting the opening degree of the opening control valve, the adjustment method can be referred to the relevant description in the above examples, which will not be described again here.

Using this method, liquid supplement can be achieved without opening the cover, and an automatic pressure control can also be achieved during the liquid supplementing process, which not only does not affect the operation of the immersion liquid cooling system, but also reduces the escape loss of immersion liquid.

Two liquid discharge methods provided by the examples of the present disclosure are introduced below.

When an IT system is turned off, or a liquid cooling device needs to be moved, immersion fluid in the liquid cooling device needs to be discharged. In the example of the present disclosure, a control apparatus can automatically start a liquid discharge mode, or can also start the liquid discharge mode after receiving a user's instruction to start the liquid discharge mode.

When a liquid discharge pipeline in examples of the present disclosure is arranged as shown in Figure 1, the method includes: after a device to be heat-dissipated in the liquid cooling device is closed, adjusting a first three-way valve so that a first liquid discharge pipeline is connected to a second pump; adjusting a second three-way valve so that a second pump is connected to a second liquid discharge pipeline; opening the cover of the liquid cooling device, so that the immersion liquid in the liquid cooling device flows into the first liquid discharge pipeline, and turning on the second pump, using the second pump to extract the immersion liquid in the first liquid discharge pipeline, so that the immersion liquid flows out of a liquid discharge port through the second liquid discharge pipeline.

A first liquid discharge mode of the immersion liquid cooling system is shown in Figure 8. In the liquid discharge mode, the immersion liquid cooling system has stopped heat dissipation, no coolant flows into a coolant inlet, the first pump is turned off, and the cover of the liquid cooling device is opened.

Wherein, the first three-way valve connects the first liquid discharge pipeline to the inlet of the second pump, while the liquid storage device is disconnected to the second pump. The second three-way valve connects the outlet of the second pump to the second liquid discharge pipeline, while the liquid area inlet of the liquid cooling device is disconnected to the second pump.

The second pump is in an on-state, under the action of the second pump, liquid in the liquid cooling device flows into the second pump along the first liquid discharge pipeline and the first three-way valve, and then passes through the second three-way valve to the second liquid discharge pipeline, finally discharges through the liquid discharge port.

Since the device to be heat-dissipated has been closed during the liquid discharging process, it will not continue to generate heat and therefore will not cause the immersion liquid to evaporate. Therefore, even if the cover of the liquid cooling device is opened, it will not cause waste of immersion liquid. In addition, in the example of the present disclosure, the control apparatus controlling the second pump can more conveniently discharge liquid.

When a liquid discharge pipeline in the example of the present disclosure is arranged as shown in Figure 2, the method includes: after the device to be heat-dissipated in the liquid cooling device is closed, adjusting the second three-way valve so that the liquid cooling device is connected to the fourth liquid discharge pipelines; adjusting the first three-way valve so that the fourth liquid discharge pipeline is connected to the inlet of the second pump; turning on the fifth solenoid valve so that the outlet of the second pump is connected to the third liquid discharge pipeline; opening the cover of the liquid cooling device so that the immersion liquid in the liquid cooling device flows into the fourth liquid discharge pipeline, and turning on the second pump, using the second pump to extract the immersion liquid in the fourth liquid discharge pipeline so that the immersion liquid flows out of the liquid discharge port through the third liquid discharge pipeline.

Specifically refer to Figure 2, in the liquid discharge mode, the immersion liquid cooling system has stopped heat dissipation, no coolant flows into the coolant inlet, the first pump is turned off, and the cover of the liquid cooling device is opened.

The second three-way valve connects the liquid area of the liquid cooling device to the fourth liquid discharge pipeline, while the liquid area of the liquid cooling device is disconnected to the outlet of the second pump.

The first three-way valve connects the fourth liquid discharge pipeline to the inlet of the second pump, while the liquid storage device is disconnected to the inlet of the second pump.

Furthermore, by turning on the fifth solenoid valve, the second pump is connected to the third liquid discharge pipeline.

Referring to the arrow in Figure 2, under the action of the second pump, after the immersion liquid in the liquid area of the liquid cooling device flows out, it enters the fourth liquid discharge pipeline through the second three-way valve, and then enters the second pump through the first three-way valve, after flowing out from the second pump, the liquid enters the third liquid discharge pipeline through the fifth solenoid valve, and finally flows out of the liquid discharge port.

It should be noted that in Figure 2, the port of the liquid area connecting pipe of the liquid cooling device can be used as an inlet or an outlet.

It can be seen from the above examples that the immersion liquid cooling system in the example of the present disclosure supports modes of air discharge, operation, liquid supplementing and liquid discharge, and in each of the above modes, the escape of immersion liquid can be reduced, and during the air discharge process and liquid supplementing process, the immersion liquid cooling system is still operating stably.

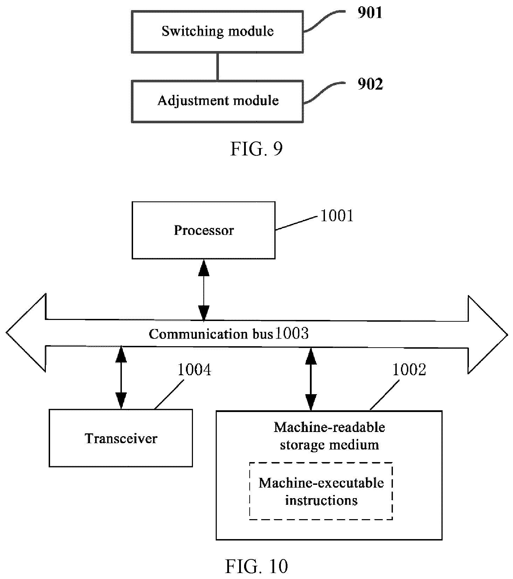

Corresponding to the above examples of the method, an example of the present disclosure further provides a control apparatus, which is located in the liquid cooling device of the immersion liquid cooling system, as shown in Figure 9, the control apparatus includes:
a switching module 901, to turn on a first pump, a first solenoid valve, a third solenoid valve and a fourth solenoid valve when a device to be heat-dissipated in the liquid cooling device is started, and turn off a second solenoid valve, so that the first pump extracts air and immersion liquid vapor from the liquid cooling device, and the air and immersion liquid vapor are allowed to enter a first condenser, the immersion liquid condensed by the first condenser flows into a liquid storage device through the third solenoid valve, the air is discharged through the first solenoid valve and an air discharge port;
an adjustment module 902, to adjust a first three-way valve to connect a second pump and the liquid storage device; adjust a second three-way valve to connect a liquid area inlet of the liquid cooling device and the second pump; adjust an opening degree of an opening control valve, to adjust pressure inside the liquid cooling device until the air discharging is completed.

In an example, the adjustment module 902 is specifically to:
obtain a pressure value collected by a pressure gage once every first preset time duration;
if pressure values collected after consecutive collections for a preset number of times show an increasing trend, reduce the opening degree of the opening control valve by a preset opening degree value;
after a second preset time duration, turn off the first pump, the first solenoid valve, the third solenoid valve and the fourth solenoid valve, and turn on the first pump, the first solenoid valve, the third solenoid valve and the fourth solenoid valve again;
return to the obtaining a pressure value collected by the pressure gage once every first preset time duration, until pressure values collected after consecutive collections for the preset number of times show a decreasing trend, then determine that the air discharging is completed.

In an example, the switching module 901 is further to turn off the first pump, the first solenoid valve, the third solenoid valve and the fourth solenoid valve;
the adjustment module 902 is further to obtain a pressure value collected by the pressure gage once every first preset time duration; if the pressure value is greater than a first pressure threshold, then increase the opening degree of the opening control valve by the preset opening degree value; if the pressure value is less than a second pressure threshold, then reduce the opening degree of the opening control valve by the preset opening degree value.

In an example, the switching module 901 is further to:
if the opening degree of the opening control valve reaches a maximum opening degree value, and if the pressure values collected after consecutive collections for the preset number of times show an increasing trend, turn on the third solenoid valve, the fourth solenoid valve, and the first pump;
if it is determined that a liquid level value recognized by a liquid level sensor in the liquid storage device is greater than or equal to a first preset height, turn on the second pump, and extract immersion liquid in the liquid storage device through the second pump, so that the immersion liquid enters the liquid cooling device along a pipeline through the liquid area inlet of the liquid cooling device.

In an example, the adjustment module 902 is further to increase a power of the first pump by a preset power value if the pressure values collected after consecutive collections for the preset number of times show an increasing trend.

In an example, the switching module 901 is further to:
if it is determined that a liquid level value recognized by the liquid level sensor of the liquid cooling device is less than a second preset height value, turn off the third solenoid valve and turn on the second solenoid valve, so that the immersion liquid entered from a liquid supplementing port flows into the liquid storage device;
use the second pump to extract the immersion liquid in the liquid storage device, so that the immersion liquid enters the liquid cooling device along the pipeline through the liquid area inlet of the liquid cooling device.

In an example, the switching module 901 is further to:
during the process of supplementing liquid for the liquid cooling device, obtain a pressure value collected by the pressure gage once every first preset time duration;
if pressure values collected after consecutive collections for the preset number of times show an increasing trend, turn on the first pump, the first solenoid valve and the fourth solenoid valve;
if a change amplitude of the pressure values collected after consecutive collections for the preset number of times is less than a preset threshold, turn off the first pump, the first solenoid valve and the fourth solenoid valve.

In an example, when the immersion liquid cooling system includes the first liquid discharge pipeline and the second liquid discharge pipeline, the adjustment module 902 is further to, after the device to be heat-dissipated in the liquid cooling device is closed, adjust the first three-way valve so that the first liquid discharge pipeline is connected to the second pump; adjust the second three-way valve so that the second pump is connected to the second liquid discharge pipeline;
the switching module 901 is further to open a cover of the liquid cooling device, so that the immersion liquid in the liquid cooling device flows into the first liquid discharge pipeline, and turn on the second pump, use the second pump to extract the immersion liquid in the first liquid discharge pipeline, so that the immersion liquid flows out of the liquid discharge port through the second liquid discharge pipeline.

In an example, when the immersion liquid cooling system includes a third liquid discharge pipeline and a fourth liquid discharge pipeline, the adjustment module 902 is further to, after the device to be heat-dissipated in the liquid cooling device is closed, adjust the second three-way valve so that the liquid cooling device is connected to the fourth liquid discharge pipeline; adjust the first three-way valve so that the fourth liquid discharge pipeline is connected to an inlet of the second pump;
the switching module 901 is further to turn on a fifth solenoid valve so that the outlet of the second pump is connected to the third liquid discharge pipeline; open the cover of the liquid cooling device so that the immersion liquid in the liquid cooling device flows into the fourth liquid discharge pipeline, and turn on the second pump, use the second pump to extract the immersion liquid in the fourth liquid discharge pipeline so that the immersion liquid flows out of the liquid discharge port through the third liquid discharge pipeline.

Corresponding to the above examples of the method, an example of the present disclosure further provides a control apparatus, which is located in the liquid cooling device of the immersion liquid cooling system, as shown in Figure 10, the control apparatus includes:
a processor 1001; a transceiver 1004; a machine-readable storage medium 1002, having stored therein machine-executable instructions that can be executed by a processor, which cause the processor 1001 to:
turn on a first pump, a first solenoid valve, a third solenoid valve and a fourth solenoid valve when a device to be heat-dissipated in the liquid cooling device is started, and turn off a second solenoid valve so that the first pump extracts air and immersion liquid vapor from the liquid cooling device, and the air and immersion liquid vapor are allowed to enter a first condenser, immersion liquid condensed by the first condenser flows into a liquid storage device through the third solenoid valve, the air is discharged through the first solenoid valve and an air discharge port;
adjust a first three-way valve to connect a second pump and the liquid storage device;
adjust a second three-way valve to connect a liquid area inlet of the liquid cooling device and the second pump;
adjust an opening degree of an opening control valve, to adjust pressure inside the liquid cooling device until the air discharging is completed.

In an example, the machine-executable instructions further cause the processor 1001 to:
obtain a pressure value collected by a pressure gage once every first preset time duration;
if pressure values collected after consecutive collections for a preset number of times show an increasing trend, reduce the opening degree of the opening control valve by a preset opening degree value;
after a second preset time duration, turn off the first pump, the first solenoid valve, the third solenoid valve and the fourth solenoid valve, and turn on the first pump, the first solenoid valve, the third solenoid valve and the fourth solenoid valve again;
return to the obtaining a pressure value collected by the pressure gage once every first preset time duration, until pressure values collected after consecutive collections for the preset number of times show a decreasing trend, then determine that the air discharging is completed.

In an example, the machine-executable instructions further cause the processor 1001 to:
turn off the first pump, the first solenoid valve, the third solenoid valve and the fourth solenoid valve;
obtain a pressure value collected by the pressure gage once every first preset time duration;
if the pressure value is greater than a first pressure threshold, then increase the opening degree of the opening control valve by the preset opening degree value;
if the pressure value is less than a second pressure threshold, then reduce the opening of the opening control valve by the preset opening degree value.

In an example, the machine-executable instructions further cause the processor 1001 to:
if the opening degree of the opening control valve reaches a maximum opening degree value, and if the pressure values collected after consecutive collections for the preset number of times show an increasing trend, turn on the third solenoid valve, the fourth solenoid valve, and the first pump;
if it is determined that a liquid level value recognized by a liquid level sensor in the liquid storage device is greater than or equal to a first preset height, turn on the second pump, and extract the immersion liquid in the liquid storage device through the second pump, so that the immersion liquid enters the liquid cooling device along a pipeline through the liquid area inlet of the liquid cooling device.

In an example, the machine-executable instructions further cause the processor 1001 to:
increase a power of the first pump by a preset power value if the pressure values collected after consecutive collections for the preset number of times show an increasing trend.

In an example, the machine-executable instructions further cause the processor 1001 to:
if it is determined that a liquid level value recognized by the liquid level sensor of the liquid cooling device is less than a second preset height value, turn off the third solenoid valve and turn on the second solenoid valve, so that the immersion liquid entered from the liquid supplementing port flows into the liquid storage device;
use the second pump to extract the immersion liquid in the liquid storage device, so that the immersion liquid enters the liquid cooling device along the pipeline through the liquid area inlet of the liquid cooling device.

In an example, the machine-executable instructions further cause the processor 1001 to:
during the process of supplementing liquid for the liquid cooling device, obtain a pressure value collected by the pressure gage once every first preset time duration;
if pressure values collected after consecutive collections for the preset number of times show an increasing trend, turn on the first pump, the first solenoid valve and the fourth solenoid valve;
if a change amplitude of the pressure values collected after consecutive collections for the preset number of times is less than the preset threshold, turn off the first pump, the first solenoid valve and the fourth solenoid valve.

In an example, when the immersion liquid cooling system includes a first liquid discharge pipeline and a second liquid discharge pipeline, the machine-executable instructions further cause the processor 1001 to:
after the device to be heat-dissipated in the liquid cooling device is closed, adjust the first three-way valve so that the first liquid discharge pipeline is connected to the second pump;
adjust the second three-way valve so that the second pump is connected to the second liquid discharge pipeline;
open a cover of the liquid cooling device, so that the immersion liquid in the liquid cooling device flows into the first liquid discharge pipeline, and turn on the second pump, use the second pump to extract the immersion liquid in the first liquid discharge pipeline, so that the immersion liquid flows out of a liquid discharge port through the second liquid discharge pipeline.

In an example, when the immersion liquid cooling system includes a third liquid discharge pipeline and a fourth liquid discharge pipeline, the machine executable instructions further cause the processor 1001 to:
after the device to be heat-dissipated in the liquid cooling device is closed, adjust the second three-way valve so that the liquid cooling device is connected to the fourth liquid discharge pipeline;
adjust the first three-way valve so that the fourth liquid discharge pipeline is connected to the inlet of the second pump;
turn on a fifth solenoid valve so that an outlet of the second pump is connected to the third liquid discharge pipeline; open a cover of the liquid cooling device so that the immersion liquid in the liquid cooling device flows into the fourth liquid discharge pipeline;
turn on the second pump, use the second pump to extract the immersion liquid in the fourth liquid discharge pipeline so that the immersion liquid flows out of a liquid discharge port through the third liquid discharge pipeline.

As shown in Figure 10, the control apparatus may further include a communication bus 1003. The processor 1001, the machine-readable storage medium 1002, and the transceiver 1004 communicate with each other through the communication bus 1003. The communication bus 1003 may be a Peripheral Component Interconnect (PCI) bus or an Extended Industry Standard Architecture (EISA) bus, etc. The communication bus 1003 can be divided into an address bus, a data bus, a control bus, and the like. The transceiver 1004 may be a wireless communication module, and the transceiver 1004 performs data interaction with other devices under the control of the processor 1001.

The machine-readable storage medium 1002 may include a Random Access Memory (RAM), and may further include a Non-Volatile Memory (NVM), such as at least one magnetic disk memory. In addition, the machine-readable storage medium 1002 may also be at least one storage device located away from the aforementioned processor.

The processor 1001 may be a general-purpose processor, comprising a Central Processing unit (CPU), a Network Processor (NP), etc.; it may also be a Digital Signal Processor (DSP), an Application Specific Integrated Circuit (ASIC), a Field-Programmable Gate Array (FPGA) or other programmable logic devices, discrete gate or transistor logic devices, discrete hardware components.

Based on the same invention concept, according to the control method for the immersion liquid cooling system provided by the above examples of the present disclosure, an example of the present disclosure further provides a machine-readable storage medium, which stores machine-executable instructions that can be executed by a processor. The machine-executable instructions cause the processor to carry out any of the above control methods for the immersion liquid cooling system.

In yet another example provided by the present disclosure, a computer program product including instructions is further provided, which, when running on a computer, causes the computer to carry out any of the control methods for the immersion liquid cooling system in the above examples.

In the above examples, it may be implemented in whole or in part by software, hardware, firmware or any combination thereof. When implemented in software, it can be implemented in whole or in part in the form of a computer program product. The computer program product includes one or more computer instructions. When the computer program instructions are loaded and executed on a computer, the processes or functions described in the examples of the present disclosure are generated in whole or in part. The computer may be a general purpose computer, special purpose computer, computer network, or other programmable device. The computer instructions may be stored in a computer readable storage medium or transmitted from one computer readable storage medium to another computer readable storage medium, for example, the computer instructions may be transmitted from a website, computer, server or data center to another website, computer, server, or data center by wire (such as coaxial cable, fiber optic, digital subscriber line (DSL)) or wirelessly (such as infrared, wireless, microwave, etc.). The computer-readable storage medium may be any usable medium that can be accessed by a computer or a data storage device such as a server and a data center and the like that includes an integration of one or more available media. The usable media may be magnetic media (such as a floppy disk, a hard disk, a magnetic tape), optical media (such as DVD), or semiconductor media (such as Solid State Disk (SSD)) and the like.

It should be noted that in this article, relational terms such as first and second are only to distinguish one entity or operation from another entity or operation, and do not necessarily require or imply any actual relationship or order between these entities or operations. Moreover, the terms "comprise", "contain", or any other variation thereof are intended to encompass non-exclusive inclusion, such that a process, method, item, or device that comprises a series of elements not only comprises those elements, but also other elements that are not explicitly listed, or also comprise elements inherent in such a process, method, item, or device. Without further limitations, the elements limited by the statement "comprising one..." do not exclude the existence of other identical elements in the process, method, item, or device that comprises the elements.

The various examples in this specification are described in a related manner. Each example focuses on the differences from other examples, and the same and similar parts between the various examples can be referred to each other. Especially, for the examples of the apparatus, the description is relatively simple because it is basically similar to the example of the method, and the relevant points can be referred to the partial description of the example of the method.

The above descriptions are only preferred examples of the present disclosure, and are not intended to limit the present disclosure. Any modifications, equivalent replacements, improvements and the like made within the spirit and principles of the present disclosure shall be included within the scope of protection of the present disclosure.

## Claims

1. An immersion liquid cooling system, comprising: a liquid cooling device, a first pump, a first condenser, a first solenoid valve, a second pump, a liquid storage device and a third solenoid valve;
wherein, a gas area outlet of the liquid cooling device is connected to one end of the first pump, the other end of the first pump is connected to an inlet of the first condenser, and an outlet of the first condenser is connected to the first solenoid valve; the first solenoid valve is connected to an air discharge port for controlling an on/off state of the air discharge port;
a liquid area inlet of the liquid cooling device is connected to one end of the second pump, and the other end of the second pump is connected to the liquid storage device;
one end of the third solenoid valve is connected to the outlet of the first condenser, and the other end of the third solenoid valve is connected to a second inlet of the liquid storage device, the third solenoid valve is to control connection/ disconnection of a pipeline between the first condenser and the second inlet of the liquid storage device.

2. The system according to claim 1, wherein the system further comprises a second solenoid valve;
a first inlet of the liquid storage device is connected to the second solenoid valve, and the second solenoid valve is connected to a liquid supplementing port for controlling an on/off state of the liquid supplementing port.

3. The system according to claim 2, wherein a second condenser is provided in a gas area of the liquid cooling device, the first condenser and the second condenser share a coolant outlet and a coolant inlet;
the coolant inlet is provided with an opening control valve, and a fourth solenoid valve is provided between the opening control valve and the first condenser, the fourth solenoid valve is to control connection/disconnection of a pipeline between the opening control valve and a condenser pipe inlet of the first condenser;
the opening control valve is further connected to a condenser pipe inlet of the second condenser.

4. The system according to claim 3, wherein the system further comprises a first liquid discharge pipeline, a second liquid discharge pipeline, a first three-way valve and a second three-way valve;
the first three-way valve is located between the second pump and the liquid storage device, and the first three-way valve is connected to the first liquid discharge pipeline;
the second three-way valve is located between the liquid area inlet of the liquid cooling device and the second pump, and the second three-way valve is connected to the second liquid discharge pipeline.

5. The system according to claim 3, wherein the system further comprises a third liquid discharge pipeline, a fourth liquid discharge pipeline, a first three-way valve, a second three-way valve and a fifth solenoid valve;
the first three-way valve is located between the second pump and the liquid storage device, and the second three-way valve is located between the liquid area inlet of the liquid cooling device and the second pump;
one end of the third liquid discharge pipeline is connected to an outlet of the second pump, and the other end of the third liquid discharge pipeline is connected to a liquid discharge port, and the fifth solenoid valve is provided between the third liquid discharge pipeline and the second pump;
one end of the fourth liquid discharge pipeline is connected to the first three-way valve, and the other end of the fourth liquid discharge pipeline is connected to the second three-way valve.

6. The system according to any one of claims 1 to 5, wherein a pressure gage is provided between the gas area outlet of the liquid cooling device and the first pump.

7. The system according to any one of claims 1 to 5, wherein a liquid level sensor is provided in the liquid cooling device.

8. The system according to any one of claims 1 to 5, wherein a liquid level sensor is provided in a liquid storage tank.

9. The system according to claim 4 or 5, wherein a control apparatus is provided in the liquid cooling device, and the control apparatus is to control the opening control valve, the first solenoid valve, the second solenoid valve, the third solenoid valve, the fourth solenoid valve, the first pump, the second pump, the first three-way valve and the second three-way valve.

10. A control method for an immersion liquid cooling system, wherein the immersion liquid cooling system is the system according to any one of claims 1 to 9, and the method is applied to a control apparatus of a liquid cooling device, and the method comprises:
when a device to be heat-dissipated in the liquid cooling device is started, turning on a first pump, a first solenoid valve, a third solenoid valve and a fourth solenoid valve, and turning off a second solenoid valve, so that the first pump extracts air and immersion liquid vapor from the liquid cooling device, allowing the air and immersion liquid vapor to enter a first condenser, immersion liquid condensed by the first condenser flows into a liquid storage device through the third solenoid valve with the air being discharged through the first solenoid valve and an air discharge port;
adjusting a first three-way valve to connect a second pump and the liquid storage device;
adjusting a second three-way valve to connect a liquid area inlet of the liquid cooling device and the second pump;
adjusting an opening degree of an opening control valve, to adjust pressure inside the liquid cooling device until the air discharging is completed.

11. The method according to claim 10, wherein adjusting the opening degree of the opening control valve, to adjust the pressure inside the liquid cooling device until the air discharging is completed, comprises:
obtaining a pressure value collected by a pressure gage once every first preset time duration;
if pressure values collected after consecutive collections for a preset number of times show an increasing trend, reducing the opening degree of the opening control valve by a preset opening degree value;
after a second preset time duration, turning off the first pump, the first solenoid valve, the third solenoid valve and the fourth solenoid valve, and turning on the first pump, the first solenoid valve, the third solenoid valve and the fourth solenoid valve again;
returning to the obtaining a pressure value collected by the pressure gage once every first preset time duration, until pressure values collected after consecutive collections for the preset number of times show a decreasing trend, determining that the air discharging is completed.

12. The method according to claim 11, wherein after the determining that the air discharging is completed, the method further comprises:
turning off the first pump, the first solenoid valve, the third solenoid valve and the fourth solenoid valve;
obtaining a pressure value collected by the pressure gage once every first preset time duration;
if the pressure value is greater than a first pressure threshold, then increasing the opening degree of the opening control valve by the preset opening degree value;
if the pressure value is less than a second pressure threshold, then reducing the opening degree of the opening control valve by the preset opening degree value.

13. The method according to claim 12, wherein the method further comprises:
if the opening degree of the opening control valve reaches a maximum opening degree value, and if the pressure values collected after consecutive collections for the preset number of times show an increasing trend, turning on the third solenoid valve, the fourth solenoid valve, and the first pump;
if it is determined that a liquid level value recognized by a liquid level sensor in the liquid storage device is greater than or equal to a first preset height, turning on the second pump, and extracting immersion liquid in the liquid storage device through the second pump, so that the immersion liquid enters the liquid cooling device along a pipeline through the liquid area inlet of the liquid cooling device.

14. The method according to claim 13, wherein the method further comprises:
increasing a power of the first pump by a preset power value if the pressure values collected after consecutive collections for the preset number of times show an increasing trend.

15. The method according to any one of claims 10 to 14, wherein the method further comprises:
if it is determined that a liquid level value recognized by the liquid level sensor of the liquid cooling device is less than a second preset height value, turning off the third solenoid valve and turning on the second solenoid valve, so that the immersion liquid entered from a liquid supplementing port flows into the liquid storage device;
using the second pump to extract the immersion liquid in the liquid storage device, so that the immersion liquid enters the liquid cooling device along the pipeline through the liquid area inlet of the liquid cooling device.

16. The method according to claim 15, wherein the method further comprises:
during the process of supplementing liquid for the liquid cooling device, obtaining a pressure value collected by the pressure gage once every first preset time duration;
if the pressure values collected after consecutive collections for the preset number of times show an increasing trend, turning on the first pump, the first solenoid valve and the fourth solenoid valve;
if a change amplitude of the pressure values collected after consecutive collections for the preset number of times is less than a preset threshold, turning off the first pump, the first solenoid valve and the fourth solenoid valve.

17. The method according to any one of claims 10 to 14, wherein when the immersion liquid cooling system comprises a first liquid discharge pipeline and a second liquid discharge pipeline, the method further comprises:
after the device to be heat-dissipated in the liquid cooling device is closed, adjusting the first three-way valve so that the first liquid discharge pipeline is connected to the second pump;
adjusting the second three-way valve, so that the second pump is connected to the second liquid discharge pipeline;
opening a cover of the liquid cooling device, so that the immersion liquid in the liquid cooling device flows into the first liquid discharge pipeline, and turning on the second pump, using the second pump to extract the immersion liquid in the first liquid discharge pipeline, so that the immersion liquid flows out of a liquid discharge port through the second liquid discharge pipeline.

18. The method according to any one of claims 10 to 14, wherein when the immersion liquid cooling system comprises a third liquid discharge pipeline and a fourth liquid discharge pipeline, the method further comprises:
after the device to be heat-dissipated in the liquid cooling device is closed, adjusting the second three-way valve so that the liquid cooling device is connected to the fourth liquid discharge pipeline;
adjusting the first three-way valve so that the fourth liquid discharge pipeline is connected to an inlet of the second pump;
turning on a fifth solenoid valve so that an outlet of the second pump is connected to the third liquid discharge pipeline;
opening a cover of the liquid cooling device so that the immersion liquid in the liquid cooling device flows into the fourth liquid discharge pipeline, and turning on the second pump, using the second pump to extract the immersion liquid in the fourth liquid discharge pipeline so that the immersion liquid flows out of a liquid discharge port through the third liquid discharge pipeline.

19. A control apparatus, wherein the control apparatus is located in a liquid cooling device of an immersion liquid cooling system according to any one of claims 1 to 9, and the control apparatus comprises:
a switching module, to turn on a first pump, a first solenoid valve, a third solenoid valve and a fourth solenoid valve when a device to be heat-dissipated in the liquid cooling device is started, and turn off a second solenoid valve so that the first pump extracts air and immersion liquid vapor from the liquid cooling device, and the air and immersion liquid vapor are allowed to enter a first condenser, immersion liquid condensed by the first condenser flows into a liquid storage device through the third solenoid valve, the air is discharged through the first solenoid valve and an air discharge port;
an adjustment module, to adjust a first three-way valve to connect a second pump and the liquid storage device; adjust a second three-way valve to connect a liquid area inlet of the liquid cooling device and the second pump; adjust an opening degree of an opening control valve, to adjust pressure inside the liquid cooling device until the air discharging is completed.

20. The control apparatus according to claim 19, wherein the adjustment module is specifically to:
obtain a pressure value collected by a pressure gage once every first preset time duration;
if pressure values collected after consecutive collections for a preset number of times show an increasing trend, reduce the opening degree of the opening control valve by a preset opening degree value;
after a second preset time duration, turn off the first pump, the first solenoid valve, the third solenoid valve and the fourth solenoid valve, and turn on the first pump, the first solenoid valve, the third solenoid valve and the fourth solenoid valve again;
return to the obtaining a pressure value collected by the pressure gage once every first preset time duration, until pressure values collected after consecutive collections for the preset number of times show a decreasing trend, then determine that the air discharging is completed.

21. The control apparatus according to claim 20, wherein:
the switching module is further to turn off the first pump, the first solenoid valve, the third solenoid valve and the fourth solenoid valve;
the adjustment module is further to obtain a pressure value collected by the pressure gage once every first preset time duration; if the pressure value is greater than a first pressure threshold, then increase the opening degree of the opening control valve by the preset opening degree value; if the pressure value is less than a second pressure threshold, then reduce the opening degree of the opening control valve by the preset opening degree value.

22. The control apparatus according to claim 21, wherein the switching module is further to:
if the opening degree of the opening control valve reaches a maximum opening degree value, and if the pressure values collected after consecutive collections for the preset number of times show an increasing trend, turn on the third solenoid valve, the fourth solenoid valve, and the first pump;
if it is determined that a liquid level value recognized by a liquid level sensor in the liquid storage device is greater than or equal to a first preset height, turn on the second pump, and extract immersion liquid in the liquid storage device through the second pump, so that the immersion liquid enters the liquid cooling device along a pipeline through the liquid area inlet of the liquid cooling device.

23. The control apparatus according to claim 22, wherein:
the adjustment module is further to increase a power of the first pump by a preset power value if the pressure values collected after consecutive collections for the preset number of times show an increasing trend.

24. The control apparatus according to any one of claims 19 to 23, wherein the switching module is further to:
if it is determined that a liquid level value recognized by the liquid level sensor of the liquid cooling device is less than a second preset height value, turn off the third solenoid valve and turn on the second solenoid valve, so that the immersion liquid entered from a liquid supplementing port flows into the liquid storage device;
use the second pump to extract the immersion liquid in the liquid storage device, so that the immersion liquid enters the liquid cooling device along the pipeline through the liquid area inlet of the liquid cooling device.

25. The control apparatus according to claim 24, wherein the switching module is further to:
during the process of supplementing liquid for the liquid cooling device, obtain a pressure value collected by the pressure gage once every first preset time duration;
if pressure values collected after consecutive collections for the preset number of times show an increasing trend, turn on the first pump, the first solenoid valve and the fourth solenoid valve;
if a change amplitude of the pressure values collected after consecutive collections for the preset number of times is less than a preset threshold, turn off the first pump, the first solenoid valve and the fourth solenoid valve.

26. The control apparatus according to any one of claims 19 to 23, wherein when the immersion liquid cooling system comprises a first liquid discharge pipeline and a second liquid discharge pipeline, the adjustment module is further to, after the device to be heat-dissipated in the liquid cooling device is closed, adjust the first three-way valve so that the first liquid discharge pipeline is connected to the second pump; and adjust the second three-way valve so that the second pump is connected to the second liquid discharge pipeline;
the switching module is further to open a cover of the liquid cooling device, so that the immersion liquid in the liquid cooling device flows into the first liquid discharge pipeline, and turn on the second pump, use the second pump to extract the immersion liquid in the first liquid discharge pipeline, so that the immersion liquid flows out of a liquid discharge port through the second liquid discharge pipeline.

27. The control apparatus according to any one of claims 19 to 23, wherein when the immersion liquid cooling system comprises a third liquid discharge pipeline and a fourth liquid discharge pipeline, the adjustment module is further to, after the device to be heat-dissipated in the liquid cooling device is closed, adjust the second three-way valve so that the liquid cooling device is connected to the fourth liquid discharge pipeline; adjust the first three-way valve so that the fourth liquid discharge pipeline is connected to an inlet of the second pump;
the switching module is further to turn on a fifth solenoid valve so that an outlet of the second pump is connected to the third liquid discharge pipeline; open a cover of the liquid cooling device so that the immersion liquid in the liquid cooling device flows into the fourth liquid discharge pipeline, and turn on the second pump, and use the second pump to extract the immersion liquid in the fourth liquid discharge pipeline, so that the immersion liquid flows out of a liquid discharge port through the third liquid discharge pipeline.

28. A control apparatus, wherein the control apparatus is located in a liquid cooling device of an immersion liquid cooling system according to any one of claims 1 to 9, and the control apparatus comprises:
a processor;
a transceiver;
a machine-readable storage medium, having stored therein machine-executable instructions that can be executed by a processor, which cause the processor to:
turn on a first pump, a first solenoid valve, a third solenoid valve and a fourth solenoid valve when a device to be heat-dissipated in the liquid cooling device is started, and turn off a second solenoid valve so that the first pump extracts air and immersion liquid vapor from the liquid cooling device, and the air and immersion liquid vapor are allowed to enter a first condenser, immersion liquid condensed by the first condenser flows into a liquid storage device through the third solenoid valve, the air is discharged through the first solenoid valve and an air discharge port;
adjust a first three-way valve to connect a second pump and the liquid storage device;
adjust a second three-way valve to connect a liquid area inlet of the liquid cooling device and the second pump;
adjust an opening degree of an opening control valve, to adjust pressure inside the liquid cooling device until the air discharging is completed.

29. The control apparatus according to claim 28, wherein the machine-executable instructions further cause the processor to:
obtain a pressure value collected by a pressure gage once every first preset time duration;
if pressure values collected after consecutive collections for a preset number of times show an increasing trend, reduce the opening degree of the opening control valve by a preset opening degree value;
after a second preset time duration, turn off the first pump, the first solenoid valve, the third solenoid valve and the fourth solenoid valve, and turn on the first pump, the first solenoid valve, the third solenoid valve and the fourth solenoid valve again;
return to the obtaining a pressure value collected by the pressure gage once every first preset time duration, until pressure values collected after consecutive collections for the preset number of times show a decreasing trend, then determine that the air discharging is completed.

30. The control apparatus according to claim 29, wherein the machine-executable instructions further cause the processor to:
turn off the first pump, the first solenoid valve, the third solenoid valve and the fourth solenoid valve;
obtain a pressure value collected by the pressure gage once every first preset time duration;
if the pressure value is greater than a first pressure threshold, then increase the opening degree of the opening control valve by the preset opening degree value;
if the pressure value is less than a second pressure threshold, then reduce the opening of the opening control valve by the preset opening degree value.

31. The control apparatus according to claim 30, wherein the machine-executable instructions further cause the processor to:
if the opening degree of the opening control valve reaches a maximum opening degree value, and if the pressure values collected after consecutive collections for the preset number of times show an increasing trend, turn on the third solenoid valve, the fourth solenoid valve, and the first pump;
if it is determined that a liquid level value recognized by a liquid level sensor in the liquid storage device is greater than or equal to a first preset height, turn on the second pump, and extract the immersion liquid in the liquid storage device through the second pump, so that the immersion liquid enters the liquid cooling device along a pipeline through the liquid area inlet of the liquid cooling device.

32. The control apparatus according to claim 31, wherein the machine-executable instructions further cause the processor to:
increase a power of the first pump by a preset power value if the pressure values collected after consecutive collections for the preset number of times show an increasing trend.

33. The control apparatus according to any one of claims 28 to 32, wherein the machine-executable instructions further cause the processor to:
if it is determined that a liquid level value recognized by the liquid level sensor of the liquid cooling device is less than a second preset height value, turn off the third solenoid valve and turn on the second solenoid valve, so that the immersion liquid entered from the liquid supplementing port flows into the liquid storage device;
use the second pump to extract the immersion liquid in the liquid storage device, so that the immersion liquid enters the liquid cooling device along the pipeline through the liquid area inlet of the liquid cooling device.

34. The control apparatus according to claim 33, wherein the machine-executable instructions further cause the processor to:
during the process of supplementing liquid for the liquid cooling device, obtain a pressure value collected by the pressure gage once every first preset time duration;
if pressure values collected after consecutive collections for the preset number of times show an increasing trend, turn on the first pump, the first solenoid valve and the fourth solenoid valve;
if a change amplitude of the pressure values collected after consecutive collections for the preset number of times is less than the preset threshold, turn off the first pump, the first solenoid valve and the fourth solenoid valve.

35. The control apparatus according to any one of claims 28 to 32, wherein when the immersion liquid cooling system comprises a first liquid discharge pipeline and a second liquid discharge pipeline, the machine-executable instructions further cause the processor to:
after the device to be heat-dissipated in the liquid cooling device is closed, adjust the first three-way valve so that the first liquid discharge pipeline is connected to the second pump;
adjust the second three-way valve so that the second pump is connected to the second liquid discharge pipeline;
open a cover of the liquid cooling device, so that the immersion liquid in the liquid cooling device flows into the first liquid discharge pipeline, and turn on the second pump, use the second pump to extract the immersion liquid in the first liquid discharge pipeline, so that the immersion liquid flows out of a liquid discharge port through the second liquid discharge pipeline.

36. The control apparatus according to any one of claims 28 to 32, wherein when the immersion liquid cooling system comprises a third liquid discharge pipeline and a fourth liquid discharge pipeline, the machine executable instructions further cause the processor to:
after the device to be heat-dissipated in the liquid cooling device is closed, adjust the second three-way valve so that the liquid cooling device is connected to the fourth liquid discharge pipeline;
adjust the first three-way valve so that the fourth liquid discharge pipeline is connected to an inlet of the second pump;
turn on a fifth solenoid valve so that an outlet of the second pump is connected to the third liquid discharge pipeline; open a cover of the liquid cooling device so that the immersion liquid in the liquid cooling device flows into the fourth liquid discharge pipeline;
turn on the second pump, use the second pump to extract the immersion liquid in the fourth liquid discharge pipeline so that the immersion liquid flows out of a liquid discharge port through the third liquid discharge pipeline.

37. A machine-readable storage medium, having stored therein machine-executable instructions that, when called and executed by a processor, cause the processor to carry out the method according to any one of claims 10 to 18.

38. A computer program product, which causes a processor to carry out the method according to any one of claims 10 to 18.
